(19) **Europäisches Patentamt**
**European Patent Office**
**Office européen des brevets**

(11) **EP 3 893 273 A1**

(12) **EUROPEAN PATENT APPLICATION**
published in accordance with Art. 153(4) EPC

(43) Date of publication:
**13.10.2021 Bulletin 2021/41**

(21) Application number: **19892539.8**

(22) Date of filing: **04.12.2019**

(51) Int Cl.:
$H01L\ 23/29$ *(2006.01)* $\qquad$ $H01L\ 23/31$ *(2006.01)*
$C09D\ 201/00$ *(2006.01)* $\qquad$ $H01L\ 21/56$ *(2006.01)*
$C09D\ 7/63$ *(2018.01)* $\qquad$ $C09D\ 7/65$ *(2018.01)*
$H05K\ 3/28$ *(2006.01)*

(86) International application number:
**PCT/JP2019/047522**

(87) International publication number:
**WO 2020/116539 (11.06.2020 Gazette 2020/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.12.2018 JP 2018230039**

(71) Applicant: **SEKISUI CHEMICAL CO., LTD.**
**Osaka-shi**
**Osaka**
**530-8565 (JP)**

(72) Inventors:
• **KUROZUMI, Satoru**
**Kyoto-shi, Kyoto 601-8105 (JP)**
• **INOUE, Masao**
**Kyoto-shi, Kyoto 601-8105 (JP)**

(74) Representative: **Ter Meer Steinmeister & Partner Patentanwälte mbB**
**Nymphenburger Straße 4**
**80335 München (DE)**

(54) **COATING AGENT, AND METHOD FOR PRODUCING ELECTRONIC COMPONENT MODULE USING SAID COATING AGENT**

(57) The present invention is to provide a coating agent that can form a coated layer having uniform heat insulating properties and suppress the electronic component from being damaged due to partial re-melting of solder or thermal expansion of the resin. The coating agent according to the present invention comprises (A) a thermoplastic resin, (B) an organic solvent, (C) a thixotropic agent, and (D) hollow particles.

EP 3 893 273 A1

**Description**

BACKGROUND OF THE INVENTION

Field of the Invention

The present invention relates to a coating agent, in particular a coating agent for protecting an electronic component from heat having various electron elements mounted on a circuit board and a method for manufacturing an electronic module using the coating agent.

Background Art

Conventionally, an electronic control unit (ECU) mounted on automobiles is generally consisted of a circuit board to which an electronic component such as a semi-conductor component is mounted and a housing for storing the circuit board. The electronic component is fixed by, for example, soldering the terminal of the electronic component to a wiring circuit pattern of the circuit board. Generally, a housing is consisted of a base which fixes the circuit board and a cover which is assembled on the base such that the circuit board is covered, as disclosed in Patent Document 1.

In recent years, there has been a need for down-sizing of such an automobile-mounted electronic control unit due to restriction of space. Along with such need, the electronic component is required for down-sizing, and as like in Patent Document 2, there is disclosed an electronic module obtained by installing an electronic component having various electron elements mounted on a circuit board in a die for injection molding, and sealing and integrating the electronic component with a thermoplastic resin.

In order to deal with environmental problems, lead-free solder has been frequently employed in the recent years, and such lead-free solder has been known to develop whiskers over time. In the automobile field as above, there is also a trend of minimizing the electronic circuit along with the down-sizing of the electronic component, and a circuit board using the lead-free solder has a problem that the adjacent electronic components cause short-circuit with each other or the solder with each other. To such problem, Patent Document 3, etc. proposes coating the solder part with hollow particles.

Prior Art

Patent Document

Patent Document 1: WO 2017/38343 A
Patent Document 2: JP2012-151296 A
Patent Document 3: JP 2013-131559 A

SUMMARY OF THE INVENTION

The present inventors have made an attempt to reduce the space that is inevitably generated between the electronic component and the exterior covering by sealing the electronic component with a thermoplastic resin by means of in-mold molding instead of protecting the electronic component with the exterior covering, and found that there is a risk of causing problem in manufacturing that the solder part on the circuit board re-melts due to the heat from the melted resin and the die at the time of in-molding, causing connection failure with the substrate. Therefore, the present inventors have made an attempt to coat the solder part by applying a coating agent comprising hollow particles and a thermoplastic resin onto the surface of the circuit board as like in Patent Document 3; however, have found a new problem that the solder part is re-melted in part.

The present inventors have conducted a further study on the new problem as above and found that the heat of the melted resin is transferred at the time of in-mold molding due to the non-uniform heat insulating properties of the coated layer formed by the coating agent, causing the solder to re-melt in part. The present inventors have found that, the use of a coating agent comprising hollow particles having a specific composition makes it possible to form a coated layer having uniform heat insulating properties and suppress the electronic component from being damaged due to partial re-melting of solder or thermal expansion of the resin. The present invention is based on such finding. That is, the object of the present invention is to provide a coating agent that can form a coated layer having uniform heat insulating properties and suppress the electronic component from being damaged due to partial re-melting of solder or thermal expansion of the resin.

Another object of the present invention is to provide an electronic component in which the soldered surface of the substrate is coated with the coating agent and a method for manufacturing the electronic component.

The present inventors have intensively studied to solve the problem as above and found that applying of a coating agent having a specific composition on a substrate makes it possible to form a coated layer having uniform heat insulating properties and the heat at the time of injection molding can suppress partial re-melting of a conductive adhesion member such as solder or stress by the thermal expansion of the resin, thereby completing the following present invention. The summary of the present invention is as described in [1] to [7] below.

[1] A coating agent comprising (A) a thermoplastic resin, (B) an organic solvent, (C) a thixotropic agent, and (D) a hollow particle.

[2] The coating agent according to [1], wherein the thermoplastic resin is contained in an amount of 5 to 40 % by mass in the coating agent.

[3] The coating agent according to [1] or [2], wherein the hollow particle has a hollowness of 40 to 95 % by volume.

[4] The coating agent according to any one of [1] to [3], wherein the hollow particle has a specific gravity of 5.0 $g/m^3$ or less.

[5] The coating agent according to any one of [1] to [4], wherein the hollow particle comprises a polyacrylonitrile or an acryl-based resin.

[6] The coating agent according to any one of [1] to [5], wherein the hollow particle is contained in an amount of 1.0 to 15 % by mass in the coating agent.

[7] A method for manufacturing an electronic module having an electronic component sealed and integrated with a thermoplastic resin, comprising:

mounting electron elements onto a circuit board and preparing an electronic component wherein the circuit board and the electron elements are electrically connected by a conductive adhesion member,

applying the coating agent according to any one of [1] to [6] on to the electronic component so that at least the conductive adhesion member is covered, and forming a coating by drying, and

placing the electronic component to which the coating is formed into a die to carry out injection molding and sealing the electronic component to which the coating is formed with a thermoplastic resin.

The coated layer formed by using the coating agent of the present invention has uniform and high heat insulating effect. Therefore, it is possible to suppress re-melting of the conductive adhesion member such as solder and heat deterioration (e.g. stress damage of the resin by thermal expansion) of the substrate due to the heat at the time of injection molding by forming a coated layer by applying the coating agent of the present invention onto the circuit board or the surface of solder before conducting in-mold molding of the thermoplastic resin onto the circuit board.

Further, the electronic component comprising the coating layer of the present invention can have improved long-term durability of the connected part of the substrate or solder since the thermoplastic resin formed by contacting with the electronic component is reduced from the heat stress generated due to thermal expansion.

DETAILED DESCRIPTION OF THE INVENTION

Mode for Carrying out the Invention

[Coating Agent]

The coating agent according to the present invention comprises (A) a thermoplastic resin, (B) an organic solvent, (C) a thixotropic agent, and (D) hollow particles as essential components and can be suitable used for forming a coating having heat resistance. For example, the coating agent according to the present invention can be suitably used for forming a heat resistant layer on the circuit board surface for protecting the circuit board from heat, as explained later. Note that, the use purpose as above is one example, and use can be obviously made to other purposes. Each of the components constituting the coating agent according to the present invention will be explained in the followings.

<(A) Thermoplastic Resin>

The coating agent according to the present invention comprises a thermoplastic resin. Conventionally known thermoplastic resins can be used, examples thereof being synthetic resins and water-based emulsion resins. Examples of the synthetic resin include polyolefin-based resins, phenol resins, alkyd resins, aminoalkyd resins, urea resins, silicon resins, melamine urea resins, epoxy resins, polyurethane resins, vinyl acetate resins, acrylic resins, chlorinated rubber-based resins, vinyl chloride resins, and fluorine resins, and one of these resins can be used, or two or more in combination. Preferred to be used among these thermoplastic resins are polyolefin-based resins, in view of the adhesiveness between the circuit board and the hollow particles, and more preferred are polyolefin-based elastomers. Particular examples of the polyolefin-based elastomers include copolymers of propylene and α olefin, α olefin polymers, ethylene-propylene-based rubbers such as ethylene-propylene rubbers (EPM), ethylene-propylene-diene rubbers (EPDM), chloro sulfonated polyethylene (CSM), and the like. Examples of the water-based emulsion include silicon acryl emulsions, urethane emulsions, and acryl emulsions.

The coating agent of the present invention preferably comprises 5 to 40 % by mass of a thermoplastic resin, and in view of shock protection of the semi-conductor, the blending amount of the thermoplastic resin is 8 to 30 % by mass and further preferably 10 to 20 % by mass. Note that, the blending amount of the thermoplastic resin as used herein means the blending amount of the thermoplastic resin in terms of solid content.

<(B) Organic Solvent>

The coating agent according to the present invention comprises an organic solvent. The organic solvent functions as a dispersion medium for dissolving or dispersing the above-described thermoplastic resin, the below-described thixotropic agent and the hollow particles. There is no limitation to the organic solvent used, as long as it possesses such function, and use can be made by appropriately selecting from conventionally known organic solvents such as ketone-, alcohol-, aromatic-based organic solvents upon taking into consideration the solubility, volatilization rate, dispersibility of the hollow particles, compatibility with other fillers and the dispersing agent. Particular examples include, acetone, methyl ethyl ketone, alkylcyclohexane, cyclohexene, ethylene glycol, propylene glycol, methyl alcohol, ethyl alcohol, isopropyl alcohol, butanol, benzene, toluene, xylene, ethyl acetate, butyl acetate and the like, among which cyclohexane having an alkyl group having 1 to 5 carbons is preferably used. These may be used alone or in combination of two or more.

When polyolefin-based resins are used as the thermoplastic resin, the organic solvent suitably used can be an aliphatic hydrocarbon having 1 to 12 carbons, in particular methylcyclohexane, in view of solubility.

The coating agent of the present invention preferably comprises 5 to 95 % by mass of the organic solvent, and in view of achieving both of ensured flowability at the time of the applying step and simplicity in the drying step after applying, the blending amount of the organic solvent is 30 to 92 % by mass and further preferably 60 to 90 % by mass.

<(C) Thixotropic agent>

The coating agent according to the present invention comprises a thixotropic agent. Containing a thixotropic agent in the coating agent in the present invention improves the dispersion stability of the thermoplastic resin and the hollow particles in the coating agent so that when a coating is formed by applying the coating agent, the thermoplastic resin and the hollow particles are dispersed uniformly in the coating (coating film), and as a result, the coated (heat insulated) layer formed with the coating agent is considered to have uniform heat insulation properties. Examples of the thixotropic agent which can be suitably used in the present invention include aliphatic amide-based compounds, oxidized polyethylene-based compounds, polyether phosphate-based compounds, and the like.

An aliphatic amide-based compound is a compound having -NH-CO- bond in the molecule, examples thereof being reaction products of fatty acid and aliphatic amine and/or alicyclic amine, and oligomers thereof. Since a compound having an amide bond forms a web-like network structure in which a hydrogen bond is involved, the formation of such network structure is considered to be involved in the uniform dispersion of the hollow particles.

The aliphatic amide compound suitably used in the present invention has a fatty acid polyamide structure, and preferred is one with the fatty acid having a long chain alkyl group having 8 to 30 carbons. Either the linear or the branched long-chain alkyl group can be used. The long-chain alkyl group may also be connected to the long-chain with a carbon-carbon bond by repetition. Specific examples of the long-chain alkyl group include saturated fatty acid monoamide such as lauric acid amide and stearic acid amide, unsaturated fatty acid monoamide such as oleic acid amide, substituted amide such as N-lauryl lauric acid amide and N-stearyl stearic acid amide, methylol amide such as methylol stearic acid amide, saturated fatty acid bisamide such as methylene bisstearic acid amide, ethylene bislauric acid amide, ethylene bishydroxy stearic acid amide, unsaturated fatty acid bisamide such as methylene bisoleic acid amide, aromatic bisamide such as m-xylylene bisstearic acid amide, ethylene oxide adduct of fatty acid amide, fatty acid ester amide, fatty acid ethanol amide, and substituted urea such as N-butyl-N'-stearyl urea, and the like, and these can be used alone or in combination of two or more. Among these, saturated fatty acid monoamide is more preferable from the viewpoint of improving the dispersibility of the hollow particles in the solution by thixotropy.

The aliphatic amide compound as above may be of one commercially available, examples being DISPARLON 6900-20X, DISPARLON 6900-10X, DISPARLON A603-20X, DISPARLON A603-10X, DISPARLON A670-20M, DISPARLON 6810-20X, DISPARLON 6850-20X, DISPARLON 6820-20M, DISPARLON 6820-10M, DISPARLON FS-6010, DISPARLON PFA-131, DISPARLON PFA-231 (manufactured by Kusumoto Chemicals Co., Ltd.), FLOWNON RCM-210 (manufactured by Kyoeisha Chemical Co., Ltd.), BYK-405 (manufactured by BYK Japan K.K.), and the like.

The oxidized polyethylene-based compound which can be used as the thixotropic agent has a portion of hydrogen of methylene modified into a hydroxyl group or a carboxyl group by contacting polyethylene with oxygen. A plurality of hydroxyl groups or carboxyl groups is present in the molecule of the oxidized polyethylene-based compound, and a hydrogen bond is formed between the oxygen element of the hydroxyl group or the carboxyl group and the hydrogen atom. Since the oxidized polyethylene-based compound forms a web-like network structure in which the hydrogen bond is involved, it is considered that the formation of such network structure is related to the uniform dispersion of the hollow particles. In the present invention, the oxidized polyethylene can be suitably used particularly as a colloid wetting dispersion by being made into fine particles.

The oxidized polyethylene-based compound as above may be of one commercially available, examples thereof being DISPARLON PF-920 (manufactured by Kusumoto Chemicals Co., Ltd.), FLOWNON SA-300H, and the like.

Examples of the polyether phosphate-based compound which can be used as the thixotropic agent include polyoxyethylene alkyl ether phosphate, polyoxyethylene alkyl phenyl ether phosphate, mono- or di- ester of higher alcohol phosphate, and the like, and alkali metal saltss, ammonium salts, and amine salts thereof. The polyether phosphate-based compound as above may be of one commercially available, examples thereof including DISPARLON 3500 (manufactured by Kusumoto Chemicals Co., Ltd.) and the like.

The coating agent according to the present invention preferably comprises 0.001 to 10 % by mass of the thixotropic agent, and in view of uniform dispersion of the hollow particles in the coating agent, the blending amount of the thixotropic agent is more preferably 0.05 to 7 % by mass and further preferably 0.1 to 1 % by mass. Note that, the content of the thixotropic agent in the present invention means the proportion of the thixotropic agent contained in relation to the sum of the (A) thermoplastic resin and the (B) organic solvent.

<(D) Hollow Particle>

The hollow particle contained in the coating agent according to the present invention imparts heat insulating properties to the coating. Such hollow particle may be either shingle-hole hollow particles or multi-hole hollow particles. Note that, the single-hole hollow particles mean particles having one hole inside the particles. The multi-hole hollow particles mean particles having a plurality of holes inside the particles. The plurality of holes in the multi-hole hollow particles may be present independently or connected.

The hollow particles are preferably having a hollowness of 40 to 95 % by volume, and in view that the heat-insulation shape can be preserved after the organic solvent is volatilized, the hollowness is more preferably 40 to 70 % by volume and further preferably 45 to 60 % by volume. Note that, the hollowness in the present invention means the value measured by the following method.

In relation to the measured value (B) of the density of the hollow particles, the theoretical density of the material forming those hollow particles is determined as (A), and the hollowness (C) can be calculated from the following formula.

$$C(\%) = (A-B)/A \times 100$$

Since the hollow particles are preferably made into a coating in a uniformly dispersed state in the thermoplastic resin, the hollow particles preferably have a specific gravity of 5.0 or less and more preferably 0.1 to 1.5. Note that, the specific gravity of the hollow particles in the present invention means the density of the hollow particles (i.e. measured value (B)) based on the density of water (1.0 g/cm$^3$).

The average particle diameter of the hollow particles is preferably 1 to 500 $\mu$m, more preferably 5 to 100 $\mu$m, and further preferably 10 to 70 $\mu$m, in view of suppressing slipping. Note that, the average particle diameter in the present invention means the average value (D50) of the particle size obtained by measuring the powder form hollow particles by means of laser diffraction scattering particle size distribution measuring method.

The hollow particles may be any of thermoplastic resin particles, thermosetting resin particles, organic hollow particles having glass shell (resin hollow particles), or inorganic hollow particles such as glass particles, ceramics particles, and the like, and in view of mechanical properties, suitable use is made to thermoplastic resin particles. Examples of the thermoplastic resins which can be used for the hollow particles include organic hollow particles having a shell of homopolymers of monomers having a styrene structure (styrene, parachloro styrene, $\alpha$-methylstyrene, etc.), monomers having a (meth)acryloyl group (acrylic acid, methacrylic acid, (meth) acrylic ester (methyl acrylate, ethyl acrylate, n-propyl acrylate, n-butyl acrylate, lauryl acrylate, nitrile acrylate, 2-ethylhexyl acrylate, methyl methacrylate, ethyl methacrylate, n-propyl methacrylate, lauryl methacrylate, 2-ethylhexyl methacrylate, etc.), monomers of vinyl acetate, vinyl ether (for example, vinyl methyl ether, vinyl isobutyl ether, etc.), vinyl ketone (vinyl methyl ketone, vinyl ethyl ketone, vinyl isopropenyl ketone, etc.), olefin (for example, ethylene, propylene, butadiene, etc.), or copolymers formed by combining two or more of these monomers.

Examples of the hollow particles also include organic hollow particles having a shell made of non-vinyl resins (epoxy resin, polyester resin, polyurethane resin, polyamide resin, polyamide resin, cellulose resin, polyether resin, modified rosin, etc.), a mixture of these resins and the vinyl resin, or a graft polymer obtained by polymerizing a vinyl monomer in the presence of these resins.

Preferably used among the above-described resins are polyacrylonitrile or acryl-based resins, in view of heat resistance.

The hollow particles may be either of expandable type or non-expandable type. Note that, the hollow particles of expandable type mean the particles in which the volume of the particles (or the holes inside) increases by external stimulation such as heat.

The hollow particles as above may be of one commercially available, examples thereof being inorganic hollow particles such as Advancel EM, HB (both manufactured by Sekisui Chemical Co., Ltd.), ExpanCel U, E (both manufactured by Nippon Ferrite Co., Ltd.), Matsumoto Microsphere F, F-E (both manufactured by MATSUMOTO YUSHI-SEIYAKU CO., LTD.), and Silinax (manufactured by Nittetsu Mining Co., Ltd.), E-spheres (manufactured by Taiyo Cement Corporation), hard light (manufactured by Showa Chemical Co., Ltd.), cenolite, marlite, glass balloon (both manufactured by TOMOE ENGINEERING CO.,LTD.), and the like.

[Electronic Substrate]

Since the coating agent according to the present invention can be used suitably for forming a coating having heat resistance as above, it can be suitably used for forming a heat-resistant layer (coating) for protecting the electronic substrate such as a circuit board from heat onto the surface of the electronic substrate. For example, to a surface of the circuit board onto which an electronic component such as a semi-conductor chip is mounted, in particular a surface soldered for electrically connecting the electronic component and the circuit board, the coating agent of the present invention can be applied and dried to remove the organic solvent to form a protective film (coating). The coating may be formed onto the entire surface of the circuit board, or only on the portion where it requires protection from the external heat.

The electronic substrate to which the coating agent of the present invention can be more suitably used is not limited to a specific substrate and preferably is a circuit board onto which a semiconductor device, a resistance chip, a condenser, a connection terminal with the outside, in particular an electronic substrate that forms various electronic control units (ECU). Various elements such as a semiconductor device, a resistance chip, a condenser, a connection terminal with the outside are mounted onto the electronic substrates such as a wiring substrate, and an electronic component in which the electronic substrate and each element are electronically connected by a conductive adhesion member such as solder is made into a module, thereby producing an electronic control unit. Various electronic control units may preferably be an electronic control unit for aircrafts or automobiles, and more preferably an electronic control unit related to sensors.

[Electronic Module]

The electronic control unit described as above have the electronic component mounted onto the electric substrate and are generally contained in a housing to be integrated for the purpose of protecting the electronic component and made into an electronic module. Since there has also been a need to downsize the electronic modules in the recent years, the electronic component per se has been sealed with a thermoplastic resin and integrated into an electronic module, instead of storing the electronic component in a housing. Such electronic module is made by placing an electronic component in a die and carrying out injection molding (in-mold molding). In this case, the heat from the melted thermoplastic resin transmits to the electronic component, causing the conductive adhesion member such as solder to re-melt, and thus the electronic component can be broken due to partial re-melting of solder or thermal expansion of the resin. By forming a coating using the coating agent of the present invention, such external heat can be shielded and the electronic component can be suppressed from being damaged. Note that, sealing the electronic component with a thermoplastic resin in the present invention means integrating or protecting the electronic component, sensors, and connector terminals with the outside with a thermoplastic resin, and portions may be present such as a part of the substrate or sensors, cables that are not covered with the thermoplastic resin.

Examples of the conductive adhesion member may be synthetic resins including a conductive filler, and solder, and solder is preferably used. Solder may preferably contain tin (Sn), and examples thereof include Sn-Pb-based alloy, Sn-Ag-Cu-based alloy, Sn-Zn-Bi-based alloy, Sn-Zn-Al-based alloy, and the like, and in view of regulations relating to environment, preference is made to the use of the so-called lead-free solder such as Sn-Ag-Cu-based alloy, Sn-Zn-Bi-based alloy, and Sn-Zn-Al-based alloy.

Examples of the resins including a conductive filler include those that contain conductive fillers such as gold, silver, copper, nickel, aluminum in thermo-setting resins such as epoxy-based resins and phenol-based resins and thermoplastic resins such as polyester-based resins, polyolefin-based resins, polyurethane-based resins, and polycarbonate-based resins.

In view of workability when electrically connecting the wiring substrate and various elements, the conductive adhesion member has a melting point of generally 250 °C or lower, preferably 220 °C or lower, more preferably 200 °C or lower, and further preferably 190 °C or lower. Note that, when a thermosetting resin and the like is used as a resin containing a conductive filler and when the thermosetting resin cannot be measured for its melting point, the melting point may be replaced by the heat-resistant temperature.

On the other hand, there is no limitation to the thermoplastic resin sealing the electronic component, as long as the resin is capable for injection molding, examples thereof being polyacetal, polyamide, polycarbonate, polybutylene terephthalate, polyethylene terephthalate, polyphenylene sulfide, polyacryl resin, ABS resin, and the like, and in view of molding and mechanical properties, preferred for use is polybutylene terephthalate.

When polybutylene terephthalate is used as the thermoplastic resin for sealing, there is a risk that the conductive adhesion member may be re-melted because the temperature at the time of injection-molding is about 230 to 270 °C. In the present invention, less heat is transmitted to the electronic component by forming a coating on the surface of the electronic component, and as a result, it is possible to suppress the electronic component from being damaged due to re-melting of the conductive adhesion member or thermal expansion of the resin as described above.

[Method for producing Electronic Component]

The method for forming a coating on the electronic component by using the coating agent according to the present invention to make an electronic module shall be explained by illustrating one example.

First of all, various electronic elements such as a semiconductor device, a resistance chip, a condenser, a connection terminal with the outside are mounted on a circuit board and an electronic component is made in which the circuit board and the electronic elements are electronically connected with a conductive adhesion member. This step can be carried out as like the conventional step for making an electronic component.

Next, a coating agent is applied onto the electronic component so that at least the conductive adhesion member of the electronic component is covered. In view of protecting the various electronic elements from heat, the coating agent is preferably applied so that the entire circuit board to which the various electronic elements are mounted is covered.

After applying the coating agent, a coating (protective film) can be formed by removing the organic solvent by drying. Drying can be a normal temperature drying or it is also possible to use a hot-air drying machine and the like.

Accordingly, an electronic component having all or a part of the conductive adhesion member part or the electronic elements covered by the protective film as above is sealed with a thermoplastic resin by conducting injection molding. It is possible to manufacture an electronic module in a desired shape having the electronic component sealed and integrated with the thermoplastic resin by carrying out in-mold molding.

EXAMPLES

Hereinafter, the present invention shall be described in more detail with reference to the Examples; however, the present invention shall not be limited by those Examples.

[Reference Example 1]

To 100 parts by mass of a mixture of a thermoplastic resin and an organic solvent (Humiseal 1B51NSLU-55 (polyolefin-based elastomer 14 % by mass, methylcyclohexane 86% by mass) manufactured by ARBROWN Co., Ltd.), 3 parts by mass of Advancel EM501 (material: acrylonitrile, specific gravity: 0.06 g/cm$^3$, hollowness: 90 %, average particle size: 65 $\mu$m) manufactured by Sekisui Chemical Co., Ltd., which had been subjected to an expansion treatment at 100 °C for 2 minutes beforehand were added as Hollow particles 1, and the mixture was sufficiently stirred to prepare a coating solution, which was then allowed to stand for 2 hours. The coating solution started solid-liquid separation from 10 minutes after each component was stirred, and solid-liquid separation was complete after 2 hours. The solid-liquid separated precipitate is considered to be Hollow particles 1.

[Reference Example 2]

A coating solution was prepared in the same manner as in Reference Example 1 except that Hollow particles 2 (Advancel HB2051 manufactured by Sekisui Chemical Co., Ltd., material: acrylonitrile, specific gravity: 0.4 g/cm$^3$, hollowness: 50 %, average particle size: 20 $\mu$m) were used in place of the Hollow particles 1, and when the dispersion state of the coating solution was confirmed in the same manner as in Reference Example 1, solid-liquid separation started from 10 minutes after each component was stirred, and solid-liquid separation was complete after 2 hours. The supernatant obtained by solid-liquid separation is considered to be Hollow particles 2.

From the evaluation results of Reference Examples 1 and 2, it was found that the coating agent composed only of the thermoplastic resin, the organic solvent, and the hollow particles has poor dispersibility, making it difficult to form an even heat insulating layer.

[Example A1]

To 100 parts by of a mixture of a thermoplastic resin and an organic solvent (Humiseal 1B51NSLU-55 (polyolefin-based elastomer 14 % by mass, methylcyclohexane 86 % by mass) manufactured by ARBROWN Co., Ltd.), were added 3 parts by mass of Hollow particles 1 and 0.3 parts by weight of an aliphatic amide compound (DISPARLON PFA-131, manufactured by Kusumoto Chemicals, Ltd.), and the mixture was sufficiently stirred to prepare a coating solution, which was then allowed to stand for 8 hours. The coating solution was in a uniform state even after 8 hours from preparation with no solid-liquid interface being confirmed.

[Example A2]

A coating solution was prepared in the same manner as in Example A1 except that FLOWNON RCM-210 manufactured by Kyoeisha Chemical Co., Ltd. was used as the aliphatic amide compound, and when the dispersion state of the coating solution was confirmed in the same manner as in Example 1, the coating solution was in a uniform state even after 8 hours from preparation with no solid-liquid interface being confirmed.

[Comparative Example A1]

A coating solution was prepared in the same manner as in Example A1 except that a modified urea (BYK-410, manufactured by BYK Japan K.K.) was used in place of the aliphatic amide compound, and when the dispersion state of the coating solution was confirmed in the same manner as in Example A1, it was found that the solid liquid completely separated after 8 hours from the preparation. The precipitate obtained by solid-liquid separation is considered to be Hollow particles 1.

From the evaluation results of Examples A1 and A2 and Comparative Example A1, it was found that the coating agent composed of a thermoplastic resin, an organic solvent, an aliphatic amide compound, and hollow particles was excellent in dispersion stability for a long time, and the uniformity was maintained from preparation of the coating solution to application.

[Example A3]

To 100 parts by mass of a mixture of a thermoplastic resin and an organic solvent (Humiseal 1B51NSLU-55 (polyolefin-based elastomer 14 % by mass, methylcyclohexane 86 % by mass) manufactured by ARBROWN Co., Ltd.) were added 2 parts by mass of Hollow particles 1 and 0.3 parts by mass of an aliphatic amide (DISPARLON PFA-131, manufactured by Kusumoto Chemicals, Ltd.), and the mixture was sufficiently stirred to prepare a coating solution.

Next, the obtained coating solution was applied onto a polyimide film using a bar coater, and the organic solvent was evaporated by drying to form a coating. The thermal conductivity of the obtained coating was measured by transient hot wire method. The measurement result is shown in Table 1 below.

[Example A4]

A coating solution was prepared in the same manner as in Example A3 except that the Hollow particles 2 were used instead of the Hollow particles 1, then a coating was formed from the coating solution in the same manner as in Example A3, and the thermal conductivity was measured. The measurement result is shown in Table 1 below.

[Example A5]

A coating solution was prepared in the same manner as in Example A3 except that Hollow particles 3 (Q-CEL7040S manufactured by Potters Co., Ltd., material: sodium borosilicate glass, specific gravity: 0.4 g/cm$^3$, hollowness: 90%, average particle diameter: 45 $\mu$m) were used instead of the Hollow particles 1, then a coating was formed from the coating solution in the same manner as in Example A3, and the thermal conductivity was measured. The measurement result is shown in Table 1 below.

[Example A6]

A coating solution was prepared in the same manner as in Example A3 except that Hollow particles 4 (Spherice 25P45 manufactured by Potters Co., Ltd., material: borosilicate glass, specific gravity: 0.25 g/cm$^3$, hollowness: 90 %, average particle size: 45 $\mu$m) were used instead of the Hollow particles 1, then a coating was formed from the coating solution in the same manner as in Example A3, and thermal conductivity was measured. The measurement result is shown in Table 1 below.

[Reference Example 3]

A coating solution was prepared in the same manner as in Example A3 except that the Hollow particles 1 were not blended in, then a coating was formed from the coating solution in the same manner as in Example A3, and the thermal conductivity was measured. The measurement result is shown in Table 1 below.

[Table 1]

| Composition | | Example A3 | Example A4 | Example A5 | Example A6 | Reference Example 3 |
|---|---|---|---|---|---|---|
| Thermoplastic resin | | Polyolefin-based elastomer (14 parts by mass) | | | | |
| Organic solvent | | methylcyclohexane (86 parts by mass) | | | | |
| Aliphatic amide | | fatty acid amide compound (0.3 parts by mass) | | | | |
| Hollow particles | Particles | Hollow Particles 1 | Hollow Particles 2 | Hollow Particles 3 | Hollow Particles 4 | - |
| | Particle specific gravity | 0.06 | 0.4 | 0.4 | 0.25 | - |
| | Hollowness | 90 vol% | 50 vol % | 90 vol % | 90 vol % | - |
| | Average particle size | 65μm | 20μm | 45μm | 45μm | - |
| | Material | Acrylonitrile | Acrylonitrile | Borosilicate Sodium Glass | Borosilicate Glass | - |
| | Additive concentration | 2 wt% | 2 wt% | 2 wt% | 2 wt% | 0 wt% |
| Thermal conductivity (W/m·K) | | 0.11 | 0.20 | 0.18 | 0.16 | 0.26 |

As is apparent from the evaluation results shown in Table 1, the coatings formed using the coating solutions of the present invention have a lower thermal conductivity than that of the coating film formed using a coating solution containing no hollow particles, all of them being below 0.2 W/m·K.

When assuming that the melting point of the solder is 217 °C and that polybutylene terephthalate is injection molded on the substrate at a mold temperature of 240 °C, and calculating by simulation the thermal conductivity required to suppress the solder from being heated above the melting point during injection molding, it was found that re-melting of the solder can be suppressed if the thermal conductivity is 0.2 W/m·K or less.

As described above, when the coating agent of the present invention is used as a coating material for a circuit board, a coating layer having uniform heat insulating properties can be formed, and the heat during injection molding can suppress re-melting of the solder and stress caused by thermal expansion of the resin.

[Example B1]

To 100 parts of a mixture of a thermoplastic resin and an organic solvent (Humiseal 1B51NSLU-40 manufactured by ARBROWN Co., Ltd. (polyolefin-based elastomer 15 % by weight, methylcyclohexane 85% by weight)) were added 6 parts by mass of Hollow particles 2 and 0.3 parts by mass of an aliphatic amide compound (PFA131 manufactured by Kusumoto Chemicals, Ltd.), and the mixture was sufficiently stirred to prepare a coating solution.

Next, the obtained coating solution was applied onto a silicone sheet using a bar coater, and the organic solvent was evaporated by drying to form a coating. The dried coating was peeled off from the silicone sheet, and four sheets of the obtained coatings were stacked, and thermal conductivity was measured in the same manner as in Example A3. The measurement result is shown in Table 2 below.

[Example B2]

A coating solution was prepared in the same manner as in Example B1 except that an aliphatic amide compound (SH1290 manufactured by Kyoeisha Chemical Co., Ltd.) was used as the thixotropic agent, and thermal conductivity was measured in the same manner as in Example B1. The measurement result is shown in Table 2 below.

[Example B3]

A coating solution was prepared in the same manner as in Example B1 except that an oxidized polyethylene-based compound (PF920, manufactured by Kusumoto Chemicals, Ltd.) was used as the thixotropic agent, and thermal conductivity was measured in the same manner as in Example B1. The measurement result is shown in Table 2 below.

[Example B4]

A coating solution was prepared in the same manner as in Example B1 except that a polyether phosphate-based compound (3500, manufactured by Kusumoto Chemicals, Ltd.) was used as the thixotropic agent, and thermal conductivity was measured in the same manner as in Example B1. The measurement result is shown in Table 2 below.

[Comparative Example B1]

A coating solution was prepared in the same manner as in Example B1 except that no thixotropic agent (aliphatic amide compound) was added, and thermal conductivity was measured in the same manner as in Example B1. The measurement result is shown in Table 2 below.

[Comparative Example B2]

A coating solution was prepared in the same manner as in Example B1 except that no hollow particles were added, and thermal conductivity was measured in the same manner as in Example B1. The measurement result is shown in Table 2 below.

[Comparative Example B3]

A coating solution was prepared in the same manner as in Example B2 except that no hollow particles were added, and thermal conductivity was measured in the same manner as in Example B2. The measurement result is shown in Table 2 below.

[Comparative Example B4]

A coating solution was prepared in the same manner as in Example B3 except that no hollow particles were added, and thermal conductivity was measured in the same manner as in Example B3. The measurement result is shown in Table 2 below.

[Comparative Example B5]

A coating solution was prepared in the same manner as in Example B4 except that no hollow particles were added, and thermal conductivity was measured in the same manner as in Example B4. The measurement results are shown in Table 2 below.

[Comparative Example B6]

A coating solution was prepared in the same manner as in Example B1 except that no hollow particles and no thixotropic agent were added, and thermal conductivity was measured in the same manner as in Example B1. The measurement result is shown in Table 2 below.

[Table 2]

| | Hollow particles | Thixotropic agent | Thermal conductivity (W/m·K) |
|---|---|---|---|
| Example B1 | Hollow Particles 2 | Aliphatic Amide Compound | 0.1230 |
| Example B2 | | Aliphatic Amide Compound | 0.1215 |
| Example B3 | | Polyethylene oxide-based compound | 0.1202 |
| Example B4 | | Polyester Phosphate Ester-based Compound | 0.1198 |
| Comparative Example B1 | | - | 0.1251 |
| Comparative Example B2 | - | Aliphatic Amide Compound | 0.1697 |
| Comparative Example B3 | | Aliphatic Amide Compound | 0.1697 |
| Comparative Example B4 | | Polyethylene oxide-based compound | 0.1535 |
| Comparative Example B5 | | Polyester Phosphate Ester-based Compound | 0.1702 |
| Comparative Example B6 | | - | 0.1617 |

**Claims**

1. A coating agent comprising:

   (A) a thermoplastic resin,
   (B) an organic solvent,
   (C) a thixotropic agent, and
   (D) a hollow particle.

2. The coating agent according to claim 1, wherein
   the thermoplastic resin is contained in an amount of 5 to 40 % by mass in the coating agent.

3. The coating agent according to claim 1 or 2, wherein
   the hollow particle has a hollowness of 40 to 95 % by volume.

4. The coating agent according to any one of claims 1 to 3, wherein
   the hollow particle has a specific gravity of 5.0 g/m$^3$ or less.

5. The coating agent according to any one of claims 1 to 4, wherein
   the hollow particle comprises a polyacrylonitrile or an acryl-based resin.

6. The coating agent according to any one of claims 1 to 5, wherein
   the hollow particle is contained in an amount of 1.0 to 15 % by mass in the coating agent.

7. A method for manufacturing an electronic module having an electronic component sealed and integrated with a thermoplastic resin, comprising:

   mounting electron elements onto a circuit board and preparing an electronic component wherein the circuit board and the electron elements are electrically connected by a conductive adhesion member,
   applying the coating agent according to any one of claims 1 to 6 onto the electronic component so that at least the conductive adhesion member is covered, and forming a coating by drying, and
placing the electronic component to which the coating is formed into a die to carry out injection molding and sealing the electronic component to which the coating is formed with a thermoplastic resin.

## INTERNATIONAL SEARCH REPORT

| International application No. |
|---|
| PCT/JP2019/047522 |

**A. CLASSIFICATION OF SUBJECT MATTER**
Int. Cl. R01L23/29(2006.01)i, R01L23/31(2006.01)i, C09D201/00(2006.01)i,
H01L21/56(2006.01)i, C09D7/63(2018.01)i, C09D7/65(2018.01)i, H05K3/28(2006.01)i
FI: C09D201/00, C09D7/63, C09D7/65, H01L23/30 D, H01L21/56 E, H05K3/28 G

According to International Patent Classification (IPC) or to both national classification and IPC

**B. FIELDS SEARCHED**

Minimum documentation searched (classification system followed by classification symbols)
Int. Cl. H01L23/29, H01L23/31, C09D1/00-201/10, H01L21/56, H05K3/28

Documentation searched other than minimum documentation to the extent that such documents are included in the fields searched
Published examined utility model applications of Japan      1922-1996
Published unexamined utility model applications of Japan    1971-2020
Registered utility model specifications of Japan            1996-2020
Published registered utility model applications of Japan    1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 60-179474 A (NIPPON PAINT CO., LTD.) 13 | 1-6 |
| A | September 1985, claim 2, page 3, lower right column, line 6 to line 9, examples 1-2, claim 2, page 3, lower right column, line 6 to line 9, examples 1-2 | 7 |
| X | JP 2015-172142 A (AISIN CHEMICAL CO., LTD.) 01 | 1-6 |
| A | October 2015, claim 1, paragraphs [0034]-[0039], examples 1-2, claim 1, paragraphs [0034]-[0039], examples 1-2 | 7 |
| A | JP 2016-141174 A (HITACHI AUTOMOTIVE SYSTEMS, LTD.) 08 August 2016, claim 7, examples 1-8 | 7 |

☒ Further documents are listed in the continuation of Box C.     ☒ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| 23.01.2020 | 04.02.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

| International application No. |
| --- |
| PCT/JP2019/047522 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | JP 2013-125755 A (TOYOTA MOTOR CORP.) 24 June 2013, claim 1, paragraph [0019] | 7 |

Form PCT/ISA/210 (continuation of second sheet) (January 2015)

**INTERNATIONAL SEARCH REPORT**

Information on patent family members

| | International application No. |
|---|---|
| | PCT/JP2019/047522 |

| Patent Documents referred to in the Report | Publication Date | Patent Family | Publication Date |
|---|---|---|---|
| JP 60-179474 A | 13.09.1985 | (Family: none) | |
| JP 2015-172142 A | 01.10.2015 | US 2015/0259497 A1 claim 1, paragraphs [0040]-[0045], examples 1-2 EP 2918647 A1 CN 104910540 A | |
| JP 2016-141174 A | 08.08.2016 | US 2018/0007778 A1 WO 2016/121472 A1 EP 3251899 A1 | |
| JP 2013-125755 A | 24.06.2013 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 201738343 A
- JP 2012151296 A
- JP 2013131559 A